# FASCICULE DE BREVET EUROPEEN

(11) **EP 1 842 220 B1**
(45) Date de publication et mention de la délivrance du brevet: **10.08.2011**
(21) Numéro de dépôt: 06709431.8
(22) Date de dépôt: 24.01.2006
(51) Int. Cl.: H01J 37/073, H01J 1/304

(54) **DISPOSITIF MICROELECTRONIQUE EMETTEUR D'ELECTRONS A PLUSIEURS FAISCEAUX**
MIKROELEKTRONISCHE VORRICHTUNG MIT MEHRFACHER ELEKTRONENSTRAHLENEMISSION
MICROELECTRONIC MULTIPLE ELECTRON BEAM EMITTING DEVICE

(30) Priorité: 27.01.2005 FR 0550235
(43) Date de publication de la demande: 10.10.2007
(73) Titulaire: Commissariat à l'Énergie Atomique et aux Énergies Alternatives, 75015 Paris (FR)
(72) Inventeur: NICOLAS, Pierre, F-38120 Saint-Egrève (FR); DESIERES, Yohan, F-38000 Grenoble (FR)
(74) Mandataire: Poulin, Gérard
(86) Numéro de dépôt international: PCT/FR2006/050047
(87) Numéro de publication internationale: WO 2006/079741

(56) Documents cités:
- WO-A2-03/041039
- WO-A2-03/041039
- WO-A2-03/054901
- WO-A2-03/054901
- US-A- 5 814 924
- US-A- 5 814 924
- US-A1- 2004 084 637
- US-A1- 2004 256 976
- BAYLOR L.R. ET AL: "Initial lithography results from the digital electrostatic e-beam array lithography concept" JOURNAL OF VACUUM SCIENCE AND TECHNOLOGY B, vol. 22, no. 6, novembre 2004 (2004-11), - décembre 2004 (2004-12) pages 3021-3024, XP002348948 cité dans la demande

## Description

### DOMAINE TECHNIQUE ET ART ANTÉRIEUR

La présente invention concerne les dispositifs d'émission électronique, et en particulier un dispositif d'émission « multi-faisceaux » apte à émettre plusieurs faisceaux d'électrons en même temps, comportant plusieurs sources primaires d'émission d'électrons en parallèle, associées à des moyens pour collecter des d'électrons issus des sources primaires et pour émettre plusieurs faisceaux d'électrons secondaires à la suite de cette collection.

L'invention trouve des applications notamment dans le domaine de la lithographie à écriture directe de couches minces par exemple lors de procédés de réalisation de circuits intégrés ou/et de micro-systèmes.

Dans le cadre de la fabrication de dispositifs microélectroniques tels que les circuits intégrés ou/et de microstructures tels que les MEMS (abréviation anglo-saxonne de "Micro Electro Mechanical Systems" soit microsystèmes electro-mécaniques), on cherche continuellement à diminuer la résolution minimale ou dimension critique de motifs que l'on est amené à réaliser dans des couches minces.

La réalisation d'un ou plusieurs motifs dans une couche mince fait appel le plus souvent à un procédé de photolithographie au cours duquel on insole une couche, par exemple à base de résine photosensible, à l'aide d'un faisceau lumineux, en particulier ultraviolet, et à travers un masque reproduisant les motifs que l'on souhaite former dans cette couche mince. La résolution minimale des motifs formés dans la couche de résine dépend alors de la longueur d'onde du faisceau lumineux utilisé. Les longueurs d'ondes employées de nos jours dans de tels procédés sont de plus en plus petites, ce qui rend le coût de ces procédés de photolithographie de plus en plus important, et rapproche ces procédés d'un domaine limite de longueur d'onde utilisable, en particulier du domaine de l'ultraviolet extrême. En conséquence ces procédés sont sur le point d'atteindre une limite de résolution au-delà de laquelle il semble difficile de réduire d'avantage les cotes minimales ou dimensions critiques des motifs.

Des procédés de lithographie qui ne font pas appel à un masque, dits à « écriture directe », notamment par faisceaux d'électrons, sont apparus. La résolution minimale que l'on est susceptible d'obtenir à l'aide de tels faisceaux est inférieure à celle qui peut être obtenue à l'aide des procédés de photolithographie à rayons U.V.

Des dispositifs de lithographie à écriture directe utilisant un seul faisceau d'électrons, de largeur comprise par exemple entre 5 et 20 nm de diamètre, ont été réalisés. Une telle gamme de largeur de faisceau conduit à des temps d'écriture d'une couche mince, longs et à une utilisation d'un tel dispositif, en particulier dans le cadre d'une production industrielle, réservée à l'insolation ou à l'écriture de zones de couches minces de faible étendue.

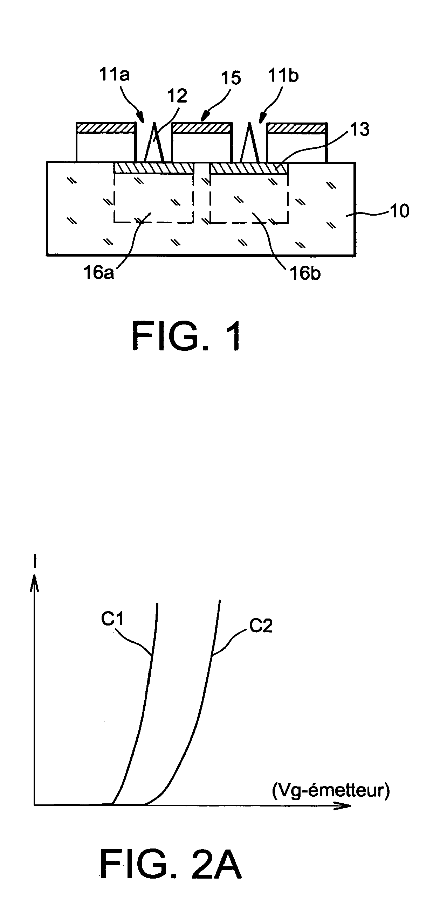

Pour diminuer le temps d'écriture de la lithographie à écriture directe, une solution décrite dans le document de L.R.Baylor et al. « Initial lithography results from the digital electrostatic e-beam array lithography concept, J. Vac. Sci. Technol. B22(6), Nov/Dec 2004 » consiste à utiliser une matrice d'émetteurs d'électrons afin de réaliser une écriture ou une lithographie de plusieurs zones en parallèle de la couche mince, à l'aide de plusieurs faisceaux d'électrons. Un exemple de dispositif d'émission électronique « multi-faisceaux » suivant l'art antérieur, comprenant une telle matrice, est illustré sur la figure 1A.

Cette matrice peut être formée sur un substrat 10 semi-conducteur et comprendre une pluralité d'émetteurs d'électrons ou pixels émetteurs d'électrons 11a, 11b, par exemple de type émetteurs à effet de champ appelés également « émetteurs froids ». Ces émetteurs 11a, 11b, peuvent être formés chacun d'une micro-pointe 12, reposant sur une couche métallique 13 et entourée de part et d'autre d'une grille d'extraction 15. De telles micro-pointes 12 utilisent le principe de l'émission par effet tunnel à travers une barrière émetteur-vide. L'intensité de faisceaux d'électrons émis par les émetteurs 11a et 11b, peut être réglée par un circuit de contrôle 16a, 16b respectif, propre à chaque émetteur 11a, 11b.

Un premier inconvénient lié à l'utilisation d'une telle matrice, est le manque d'uniformité, du point de vue l'intensité, qui peut apparaître entre des faisceaux issus d'émetteurs différents 11a et 11b. Ce manque d'uniformité est illustré sur la figure 2A, par les courbes C₁ et C₂, représentatives des caractéristiques courant-tension respectives de l'émetteur 11a et de l'émetteur 11b. Ces instabilités peuvent être dues notamment à la manière dont ont été réalisées les micro-pointes 12, et en particulier à des différences de forme ou/et de taille entre ces micro-pointes 12.

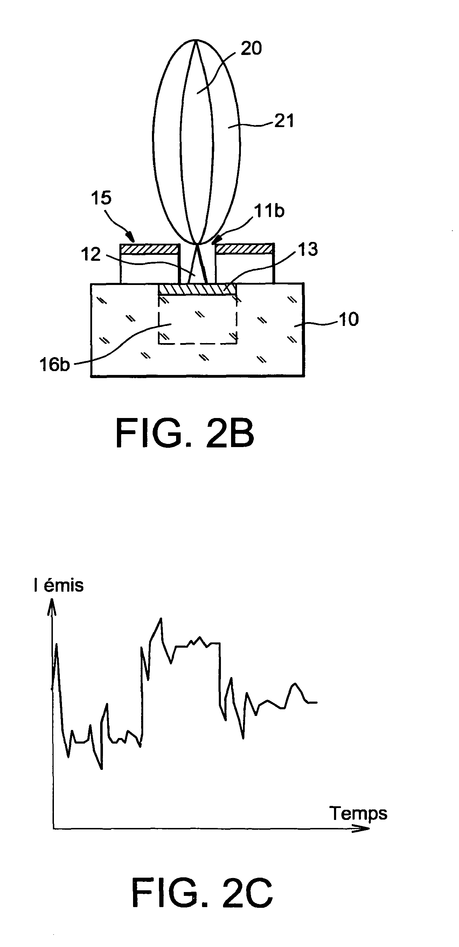

Chaque élément émetteur 11b peut connaître également des instabilités propres, et notamment des instabilités « spatiales » du faisceau qu'il émet. De telles instabilités sont illustrées sur la figure 2B, par les variations de largeur entre un faisceau d'électrons 20, qui, émis à un instant t₁ par une micro-pointe 12, a une largeur donnée, et ce même faisceau 21, qui, émis à un autre instant t₂ après l'instant t₁, à une largeur différente à la largeur donnée. Ces instabilités peuvent être dues à l'existence de plusieurs sites d'émission différents sur une même micro-pointe 12 d'un émetteur 11b.

Chaque élément émetteur 11b peut également connaître des instabilités au cours du temps (figure 2C) au niveau de l'intensité du faisceau qu'il émet. Ces instabilités peuvent être dues à une fluctuation au cours du temps du nombre de sites émetteurs d'électrons dont une micro-pointe 12 est dotée.

Pour effectuer une lithographie d'une couche mince, par exemple à base de la résine, à l'aide d'un tel dispositif, il s'agit de contrôler la quantité de charges déposée sur cette résine. Le contrôle de cette charge passe par la maîtrise d'un couple courant émis/temps d'insolation, et ce, pour chaque émetteur individuel de la matrice. Les inconvénients et instabilités évoqués précédemment rendent cette maîtrise difficile. La stabilité des émetteurs peut être également affectée par la qualité du vide ainsi que par la nature de gaz présents dans les enceintes dans lesquels on effectue la lithographie, en particulier à cause de dégazages induits par l'écriture de résine. Pour palier aux différents problèmes évoqués ci-dessus, une solution consiste à utiliser des circuits intégrés de régulation spécifiques (ASIC pour Application Specific Integrated Circuit) par exemple de type CMOS (CMOS pour Complementary Metal Oxide Semi-conductor) comme circuits de contrôle respectifs 16a, 16b de chaque émetteur 11a, 11b. Ce type de circuit de proximité est consommateur de place et limite ainsi fortement le nombre d'émetteurs que la matrice est susceptible de comporter. Ces circuits de contrôle peuvent par ailleurs avoir un fonctionnement correct à condition que les émetteurs 11a, 11b présentent un rapport signal à bruit suffisant. Dans certains cas, si les variations du courant émis par les émetteurs 11a, 11b sont trop brutales ou/et trop intenses, le circuit de contrôle ASIC peut ne plus être en mesure d'effectuer de correction.

### EXPOSÉ DE L'INVENTION

La présente invention comme revendiquée permet notamment de diminuer les phénomènes d'instabilité temporelle et spatiale des faisceaux d'électrons et de manque d'uniformité entre ces faisceaux dans les dispositifs émetteurs d'électrons « multifaisceaux ».

L'invention comme revendiquée concerne un dispositif selon la Revendication 1, en particulier microélectronique et/ou réalisé en couches minces, émetteur d'électrons et apte à émettre plusieurs faisceaux d'électrons, comprenant :
- des premiers moyens comportant au moins un premier substrat et une pluralité N1 (avec N1 un nombre entier supérieur à 1) de sources ou micro-sources d'électrons formées sur un premier substrat,
- des seconds moyens aptes à collecter des électrons issus desdites micro-sources et à émettre d'autres électrons suite à cette collection, lesdits seconds moyens comprenant au moins une couche dite « de collection » située en regard des micro-sources et dans laquelle est formée, une pluralité d'émetteurs secondaires d'électrons, par exemple une pluralité ou un nombre N2 (N2>1) d'ouvertures.

Le nombre N2 d'ouvertures est inférieur ou très inférieur au nombre N1 de micro-sources. Cela peut permettre à chacune des ouvertures d'émettre un faisceau secondaire d'électrons, résultat d'une collection d'électrons provenant de sources primaires d'électrons différentes. N1 peut être par exemple supérieur ou égal à 100*N2, ou supérieur ou égal à 1000*N2.

Certaines micro-sources peuvent éventuellement être situées en regard des ouvertures, tandis qu'une ou plusieurs micro-sources peuvent être situées en regard d'une portion non ajourée de la couche de collection. Ainsi, certaines parties non ajourées de la couche de collection sont susceptibles d'être bombardées par des micro-sources d'électrons situées en regard.

Les ouvertures ont un diamètre de l'ordre du nanomètre, qui est compris entre 1 et 50 nanomètres, et forment des sources secondaires d'électrons de dimension nanométrique, ou sources que l'on nommera « nano-sources ».

L'uniformité des faisceaux d'électrons émis avec un tel dispositif, est améliorée par rapport à celle des dispositifs de l'art antérieur. Cette uniformité dépend plus de la manière dont ont été fabriqués les émetteurs secondaires ou les ouvertures appartenant aux seconds moyens, que de celle dont ont été fabriqués les émetteurs primaires appartenant aux premiers moyens.

La stabilité temporelle de chaque faisceau émis par un tel dispositif peut également être améliorée par rapport à celle des faisceaux émis par les dispositifs de l'art antérieur. Les instabilités peuvent être réduites jusqu'à un facteur √K, avec K le nombre de micro-sources ou d'émetteurs primaires des premiers moyens, rapportés au nombre d'émetteurs secondaires ou d'ouvertures des seconds moyens.

Le nombre de micro-sources dans un tel dispositif peut être élevé. Ces micros-sources étant associées à des sources secondaires, un tel dispositif est également amélioré en terme de fiabilité, dans la mesure où la défaillance éventuelle de quelques micro-sources peut ne pas perturber ou ne perturber que très peu le fonctionnement du dispositif, et en particulier la formation de faisceaux secondaires issus des seconds moyens.

Dans un tel dispositif, les micro-sources ou/et les ouvertures peuvent être agencé(e)s en une matrice. Les premiers moyens peuvent comprendre une matrice de pixels, pour laquelle chaque pixel comprend plusieurs micro-sources et est associé à une nano-source ou une ouverture des seconds moyens.

Selon plusieurs possibilités de mise en oeuvre les micro-sources peuvent être par exemple des micro-pointes ou pointes « de Spindt », ou des nanotubes de carbones, ou des nanofissures aptes à émettre des électrons.

La couche de collection peut comporter un matériau favorisant l'émission secondaire, ou un matériau de coefficient d'émission secondaire supérieur à 1.

Les premiers moyens peuvent comprendre un élément, jouant le rôle de cathode ou plusieurs éléments jouant le rôle de cathodes, et une pluralité de micro-sources par cathode. Ces différentes cathodes peuvent être agencées selon une matrice.

Selon la Revendication 1, les premiers moyens et les seconds moyens sont « hybridés » ou solidarisés par plusieurs éléments conducteurs comme revendiqués, par exemple des billes métalliques pour former une structure.

La couche de collection des seconds moyens peut appartenir à un empilement de plusieurs couches minces. Cet empilement peut comprendre, de part et d'autre de la couche de collection, au moins une couche conductrice apte à former une première électrode et au moins une autre couche conductrice apte à former une seconde électrode.

Ces électrodes peuvent être prévues pour, lorsqu'elles sont polarisées, appliquer un champ électrique permettant de diriger des électrons secondaires émis ou renvoyés par la couche de collection, vers lesdites ouvertures, et pour accélérer ces électrons lorsqu'ils traversent ces ouvertures.

La première électrode et la seconde électrode peuvent être polarisées à l'aide d'un ou plusieurs circuits intégrés au premier substrat. Ces circuits d'alimentations sont ainsi reliés électriquement à la première et à la deuxième électrode, via lesdits éléments conducteurs.

Selon une possibilité de mise en oeuvre, la couche de collection peut être une couche mince à base d'un matériau isolant par exemple un matériau céramique éventuellement recouvert d'un autre matériau isolant de coefficient d'émission secondaire supérieur à 1, tel que par exemple du MgO.

Le dispositif microélectronique d'émission électronique selon l'invention, peut comprendre en outre : un circuit d'adressage des micro-sources intégré au premier substrat. Ce circuit d'adressage peut être éventuellement commun à toutes les micro-sources. L'adressage réalisé par ce circuit peut être de type « matrice active ».

Les contraintes de réalisation d'un tel dispositif sont également réduites par rapport aux dispositifs de l'art antérieur, notamment en ce qui concerne le circuit d'adressage. Le dispositif suivant l'invention, peut comprendre un circuit d'adressage plus simple et moins encombrant que les circuits d'adressage de type ASIC. Etant donné la possibilité de faire fonctionner en parallèle un nombre important micro-sources dans le dispositif suivant l'invention, le courant requis par micro-source est réduit. Ainsi, la gamme de tension de commande des micro-sources appliquée par le circuit d'adressage du dispositif suivant l'invention, peut être inférieure à celle(s) appliquée(s) dans les dispositifs de l'art antérieur. Cela peut permettre de réaliser le circuit intégré d'adressage dans des filières technologiques plus rapides et utilisant des gammes de tensions plus basses que celles des circuits d'adressage des dispositifs émetteurs d'électrons suivant l'art antérieur.

La réduction des contraintes de réalisation du circuit intégré de contrôle ou d'adressage et le gain de place dans le premier substrat lié à cette réduction peuvent permettre d'obtenir une importante bande passante d'écriture et une cadence d'écriture de chacun des faisceaux émis par le dispositif plus importante qu'avec les dispositifs suivant l'art antérieur.

Selon une variante de mise en oeuvre, le dispositif microélectronique d'émission d'électrons selon l'invention, peut comprendre parmi ladite pluralité de micro-sources, une première pluralité de micro-sources reposant sur une première zone conductrice et formant avec cette première zone conductrice ou semi-conductrice, une première cathode, et au moins une autre pluralité de micro-sources reposant sur une seconde zone conductrice, et formant avec cette seconde zone conductrice ou semi-conductrice une seconde cathode, isolée de, ou disjointe de, ou qui n'est pas en contact avec la première zone.

Ainsi, les premiers moyens peuvent comprendre, sur le premier substrat, au moins une première cathode et au moins une deuxième cathode isolée ou disjointe de la première cathode, partageant le même circuit d'adressage que la première cathode.

Un dispositif de lithographie, comprenant un dispositif microélectronique apte à émettre plusieurs faisceaux tel défini plus haut est prévu selon l'invention comme revendiquée.

Ce dispositif de lithographie peut comprendre en outre : des moyens de focalisation de faisceaux d'électrons, par exemple des dispositifs électrostatique(s) ou/et magnétique(s), par exemple un système de projection magnétique, ou un système combinant des lentilles électrostatiques et/ou magnétiques. Un tel dispositif de lithographie peut comprendre en outre des moyens formant une anode. Cette anode peut être par exemple une plaque semi-conductrice polarisée, recouverte d'une couche mince dans laquelle on souhaite réaliser des motifs.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 représente un exemple de dispositif d'émission électronique à plusieurs faisceaux d'électrons, suivant l'art antérieur,
- les figures 2A-2C illustrent des défauts ou dérives que peuvent connaître des faisceaux d'électrons émis à l'aide de dispositifs a plusieurs faisceaux d'électrons suivant l'art antérieur,
- la figure 3A représente un premier exemple de dispositif d'émission électronique à plusieurs faisceaux d'électrons suivant l'invention, et un empilement de couches minces compris dans un tel dispositif,
- la figure 3B illustre un mode de fonctionnement d'un dispositif suivant l'invention,
- les figures 4A et 4B représentent des variétés d'empilements de couches minces compris dans un dispositif suivant l'invention,
- la figure 5 illustre un dispositif de lithographie à écriture directe suivant l'invention,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

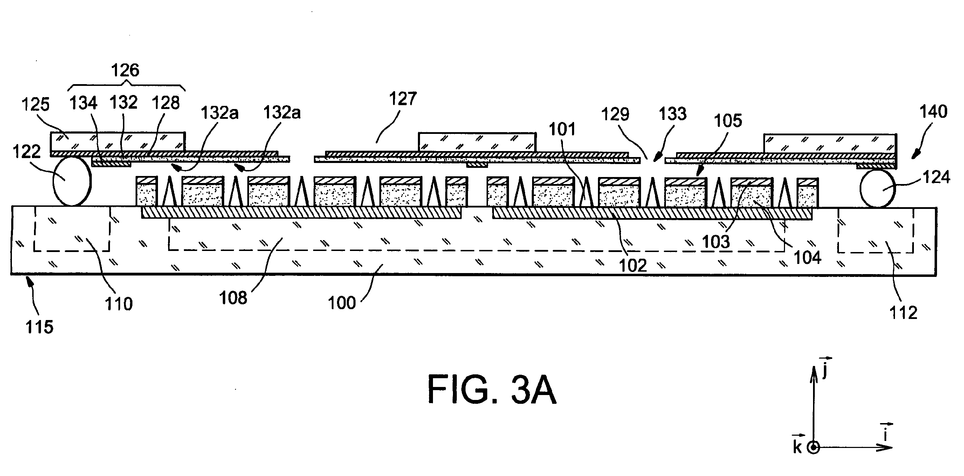

Un dispositif microélectronique, mis en oeuvre suivant l'invention, apte à émettre plusieurs faisceaux d'électrons, va à présent être décrit en liaison avec la figure 3A.

Ce dispositif comprend tout d'abord une première structure ou des premiers moyens 115 réalisés en couches minces, aptes à émettre plusieurs faisceaux d'électrons. Ces premiers moyens 115 comprennent un substrat 100 par exemple à base de matériau semi-conducteur, sur lequel repose une pluralité d'éléments 105 émetteurs d'électrons, par exemple du type émetteurs à effet de champ ou émetteurs « froids ». Ces éléments 105 émetteurs d'électrons peuvent être arrangés sous forme d'une matrice, et seront alors également appelés « pixels ».

Chaque élément ou pixel 105 peut comprendre une pluralité de sources primaires d'électrons appelées « micro-sources », telles par exemple des micro-pointes 101, ou pointes dites de « Spindt », à base d'un matériau semi-conducteur ou conducteur, et de hauteur qui peut être de l'ordre de un ou plusieurs micromètres par exemple de 1 µm. Les micro-pointes 101 d'un pixel 105 peuvent être entourées de part et d'autres d'une grille d'extraction, à base d'un matériau de grille 103 par exemple un métal tel que du Al, ou du Ti, ou du TiN, ou du Nb, reposant sur un isolant 104 de grille par exemple à base de SiO₂ ou de HfO₂, lui même reposant sur une zone conductrice ou semi-conductrice 102.

Selon une possibilité (non représentée) un pixel 105 peut comprendre plusieurs micro-sources juxtaposées, par exemple des micro-pointes juxtaposées, disposées dans une ouverture d'une couche de matériau de grille ajourée.

Les éléments ou pixels 105 peuvent comprendre une zone conductrice ou semi-conductrice apte à servir de cathode, sur laquelle les micro-sources sont formées. Chaque élément ou pixel 105 peut éventuellement comprendre une zone conductrice ou semi-conductrice 102 sur laquelle les micro-sources sont formées et qui peut être isolée ou disjointe ou ne pas être en contact avec les zones conductrices respectives des autres pixels.

Les premiers moyens 115 peuvent être formés d'une matrice par exemple comprise entre 100*100 pixels 105 et 1000*1000 pixels 105. Le nombre de micro-sources par pixel ou élément émetteur 105 peut quant à lui être élevé, par exemple compris entre 100 et plusieurs milliers de micro-pointes 101 par pixel 105.

Les premiers moyens 115 comprennent également un circuit d'adressage 108 des éléments 105 de la matrice, relié aux différentes zones conductrices 102. Le circuit d'adressage peut être réalisé par exemple en technologie CMOS (CMOS pour « Complementary Metal Oxide Semi-conductor » ou « semi-conducteur à oxyde de métal complémentaire »).

L'adressage des éléments émetteurs 105 peut être du type de celui d'une matrice active. Ainsi, les pixels ou éléments émetteurs 105 de la matrice sont susceptibles d'émettre en même temps. Chacun de ces éléments émetteurs 105 peut être également respectivement associé à des moyens de mémorisation (non représentés) propres du circuit d'adressage 108. Ces moyens de mémorisation sont aptes à mémoriser une valeur de consigne relative à l'intensité que les éléments sont destinés à émettre. Cette consigne pourra être modifiée, éventuellement individuellement pour chaque pixel, par le circuit d'adressage, au cours d'une émission d'électrons.

Une seconde structure ou des seconds moyens émetteurs d'électrons 140, sont placés en regard des premiers moyens 115 et prévus, quant à eux, pour collecter des électrons primaires issus des micro-sources de la première structure 115 et pour ré-émettre des électrons secondaires suite à cette collection.

La seconde structure 140 peuvent comprendre un deuxième substrat 125, par exemple à base d'un matériau semi-conducteur tel que du silicium ou d'un matériau conducteur, par exemple un matériau métallique, sur lequel repose un empilement 126 de couches minces placé en regard des micro-pointes 101.

L'empilement 126 peut comprendre notamment une couche métallique 128, structurée ou gravée, par exemple à base de TiN et d'épaisseur par exemple de l'ordre de 0,1 1 micromètres, formée sur le deuxième substrat 125. Cette couche métallique 128 est destinée à être polarisée et à jouer le rôle d'une première électrode. La couche métallique 128 est en contact avec une face d'une couche isolante 132, par exemple à base d'un matériau céramique d'épaisseur qui peut être comprise entre 0,1 µm et 1 µm.

Des zones de l'autre face de la couche isolante 132, qui ne sont pas situées en regard d'un élément émetteur 105, sont recouvertes d'une autre couche structurée ou gravée à base de matériau métallique 134 par exemple du TiN d'épaisseur qui peut être comprise entre 0,1 µm et 1 µm. Cette autre couche métallique 134 est destinée à être polarisée et à servir de seconde électrode.

Certaines parties notées 132a, de la couche isolante 132, situées en regard de micro-pointes 101, sont quant à elles dévoilées. Ces parties 132a de la couche isolante 132 sont destinées à être bombardées par des électrons provenant des micro-pointes 101 et à former suite à ce bombardement, des sites d'émission secondaire d'électrons. Les parties 132a peuvent être recouvertes d'un matériau isolant, ayant de préférence un fort coefficient d'émission secondaire, tel que le MgO.

La couche isolante 132 comporte également une pluralité d'ouvertures 133, qui peuvent être également agencées selon une matrice, par exemple de sorte que chaque pixel 105 est situé en regard d'une ouverture et, éventuellement, d'une seule ouverture. Les ouvertures 133 ont un diamètre compris entre 1 nanomètre et 50 nanomètres, par exemple de l'ordre de 10 nanomètres.

Les ouvertures 133 forment des sources d'émission secondaire d'électrons que l'on appellera « nano-sources ». Le nombre d'ouvertures 133, situés en regard d'un élément émetteur 105 ou d'un pixel de la première matrice est différent de celui du nombre de micro-pointes 101 ou de micro-sources dudit pixel 105. Le nombre d'ouvertures 133 dans la matrice peut être compris par exemple entre plusieurs centaines et 1 million. Le nombre total d'ouvertures 133 de la seconde structure est inférieur à celui du nombre de micro-pointes ou de micro-sources de la première structure. Une ouverture 133 est associée à plusieurs micro-sources.

Ainsi, une nano-source, est prévue pour collecter des électrons issus de plusieurs micro-sources primaires d'électrons différentes, et pour réaliser une émission secondaire d'électrons résultante, suite à cette collection, et permettre ainsi d'effectuer une moyenne temporelle ou/et spatiale de l'émission des sources primaires. Le diamètre des ouvertures 133 est prévu pour permettre une localisation spatiale précise de l'émission secondaire résultante.

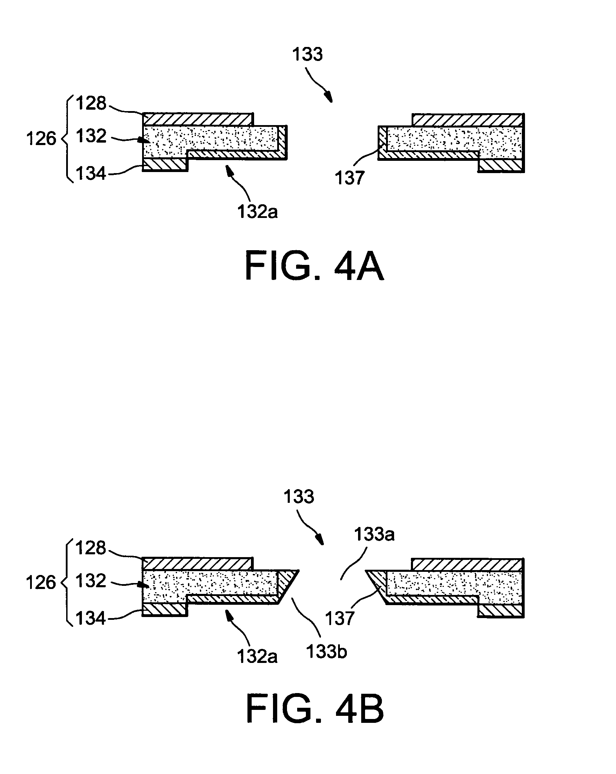

Selon une variante de mise en oeuvre de l'empilement 126, illustrée sur la figure 4A, les ouvertures 133 peuvent comporter des parois recouvertes d'un matériau 137 permettant de favoriser l'émission secondaire, tel que par exemple du MgO. Ainsi, les parois des ouvertures 133 et les parties 132a de la couche 132 peuvent être recouvertes d'un matériau favorisant l'émission secondaire.

Selon une variante de mise en oeuvre de l'empilement 126, illustrée sur la figure 4B, les ouvertures 133 peuvent également avoir une forme en biseau et/ou comporter une première embouchure 133a, située du côté de la face sur laquelle repose la couche conductrice 128 ou première électrode, de section plus faible que son autre embouchure 133b, située du côté de la face sur laquelle repose la couche à base de matériau conducteur 134 ou deuxième électrode.

Pour permettre le passage de faisceaux d'électrons à travers l'empilement 126 et le substrat 125, la première couche métallique 128 comprend des orifices 129 dans le prolongement des ouvertures 133 de diamètre par exemple de l'ordre de 1 µm, tandis que le deuxième substrat 125 comprend des orifices 127 de diamètre par exemple de l'ordre de 10 µm dans le prolongement des orifices 129 (les diamètres des ouvertures 133, orifices 129 et 127 étant mesurés dans des directions parallèles à un vecteur ***̅i̅*̅** d'un repère orthogonal [O; ***̅i̅*̅** ; ***̅j̅*̅** ; ***̅k̅*̅**] indiqué sur la figure 3A).

La deuxième structure 140, est rattachée ou liée mécaniquement ou solidarisée à la première structure 115. Dans cet exemple, la deuxième structure 140 repose sur des éléments conducteurs formés de chaque côté de la première structure 110. La deuxième structure 140 est ainsi maintenue par lesdits éléments conducteurs au dessus de la première structure, à une distance par exemple de l'ordre de plusieurs micromètres ou de plusieurs centaines de micromètres. Ces éléments conducteurs peuvent être par exemple des billes métalliques 122 et 124, dites « billes d'hybridation » de diamètre compris par exemple entre plusieurs micromètres et plusieurs centaines de micromètres, à base d'un métal ou d'un alliage métallique, éventuellement fusible. Les éléments conducteurs 122 et 124, sont respectivement en contact avec la couche métallique 128 servant de première électrode, et avec le matériau métallique 134 servant de seconde électrode, et permettent respectivement, de relier électriquement la première électrode à des premiers moyens d'alimentation 110 intégrés au premier substrat 100, et la seconde électrode, à des seconds moyens d'alimentation 112 également intégrés au premier substrat 100.

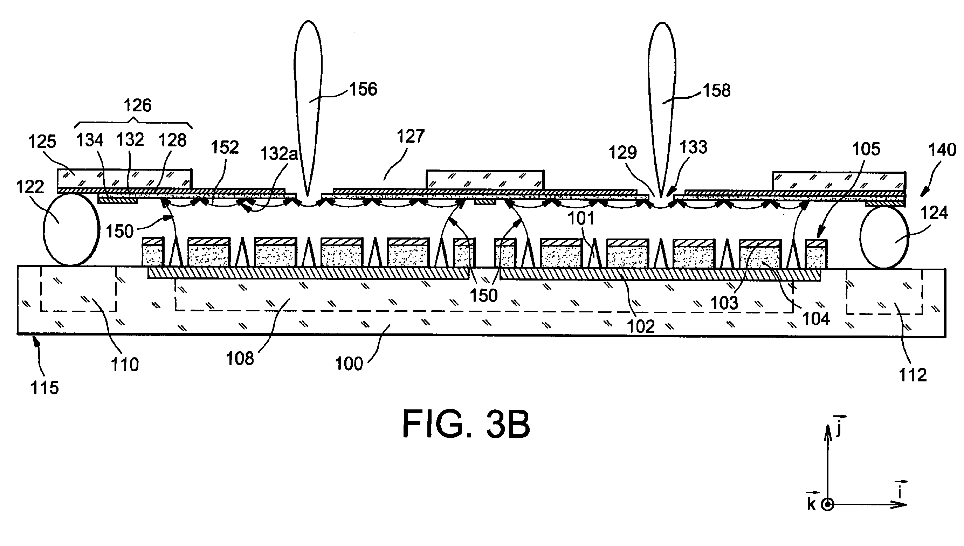

Le fonctionnement du dispositif, peut être le suivant : lorsque les micro-sources 101 d'un pixel 105 émettent des électrons primaires (l'émission d'électrons primaires étant représentée par des traits fléchés notés 150 sur la figure 3B), certains de ces électrons sont susceptibles d'entrer en collision sur les parties 132a de la couche collectrice 132 de l'empilement 126, ainsi que sur les parois des ouvertures 133. Ces collisions peuvent permettre de produire des électrons secondaires.

Les parties 132a de la couche collectrice 132 de l'empilement 126 collectent ainsi « spatialement » et moyennent les électrons primaires provenant de plusieurs micro-sources différentes.

Parallèlement, la première électrode et la seconde électrode, peuvent être polarisées de manière à produire un champ électrique tangentiel et radial doté notamment d'au moins une composante parallèle au vecteur ***̅i̅*̅** et d'au moins une autre composante parallèle au vecteur ***̅j̅*̅** du repère orthogonal [0;***̅i̅*̅**; ***̅j̅*̅**; ***̅k̅*̅**] indiqué sur la figure 3B permettant d'une part, après éventuellement plusieurs étapes de réémission ou sauts des électrons secondaires (les émissions et les sauts d'électrons secondaires étant représentée par des traits fléchés notés 152 sur cette même figure 3B) produits sur les parties 132a de la couche isolante 133 de l'empilement 126, d'acheminer ou de ramener ces électrons secondaires vers les ouvertures 133. Ces ouvertures 133, forment alors une source secondaire ou une nano-source d'électrons. La première électrode et la seconde électrode permettent de regrouper les électrons secondaires en des faisceaux d'électrons 156, 158 et d'accélérer le flux d'électrons de ces faisceaux 156, 158 en sortie des ouvertures 133, puis des orifices 127 et 139.

Ainsi, la matrice d'ouvertures 133 permet de combiner ou de moyenner pour chaque pixel ou élément émetteur 105, les dispersions spatiales ainsi que les fluctuations temporelles des faisceaux d'électrons émis par les micro-sources. Cette matrice d'ouvertures 133 permet également de former des sources secondaires d'électrons indépendantes des instabilités spatiales d'émission des micro-sources 101 ou sources primaires. On peut obtenir en sortie des nano-sources, des faisceaux 156, 158 ayant chacun des caractéristiques de stabilité spatiale et de stabilité temporelle d'intensité améliorée par effet de moyenne, ainsi que pour l'ensemble des faisceaux, une uniformité de caractéristiques entre ces derniers.

Les faisceaux d'électrons 156, 158 en sortie des ouvertures 133 peuvent avoir une largeur faible par exemple de l'ordre de 10 à 20 nm, et une densité de courant importante. Cette densité de courant peut être par exemple de l'ordre de 10⁴ A/cm², pour un courant émis de 10 nA par nanosource 133.

Le dispositif suivant l'invention n'est pas limité à des micro-sources d'électrons primaires de type micro-pointes. Ainsi, selon des variantes de mise en oeuvre du dispositif précédemment décrit, les cathodes à base de micro-pointes peuvent être remplacées par des cathodes comportant des micro-sources d'électrons de nature différentes, par exemple des nano-tubes de carbone tels que décrits dans le document de J. Dijon et al, « LN-2: Cathode Structures for Carbon Nanotubes Displays », Proceedings of the 22nd international display research conference, Eurodisplay, Nice 2002. Late news papers, pp 821-824*,* ou selon, une autre possibilité, des nano-fissures tels que décrits dans le document de K. Sakai and al. « Flat Panel Displays Based on Surface Conduction Electron emitters », Proceedings of the 16th international display research conference, Ref 18.3L., pp 569-572*.*

Après réalisation de la première structure et de la deuxième structure, une étape d'assemblage des deux structures, que l'on appelle également « hybridation », peut être réalisée, à l'aide par exemple de billes conductrices 122 et 124 d'hybridation, réalisées par exemple en un matériau fusible. Ces billes permettent, outre d'établir une liaison électrique et mécanique entre les deux structures, de positionner de manière précise les deux matrices de micro-sources et d'ouvertures l'une par rapport à l'autre, selon une précision de l'ordre par exemple du micron.

Le dispositif émetteur d'électrons apte à produire plusieurs faisceaux d'électrons 156, 158 qui vient d'être décrit est utilisé dans le cadre de la lithographie à écriture directe, pour la réalisation dans des couches minces, de motifs de dimension critique très faible, par exemple de l'ordre de 15 ou 20 nanomètres.

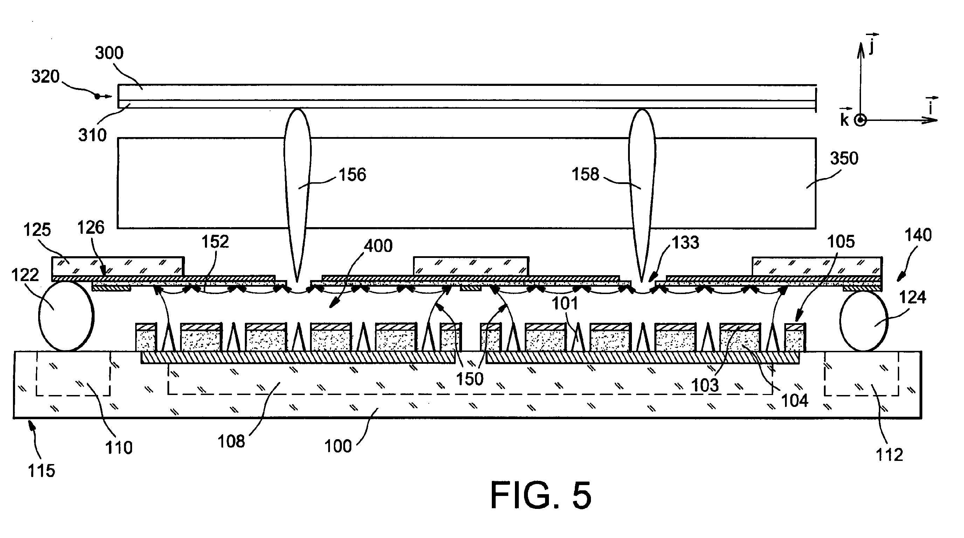

La figure 5 illustre un dispositif de lithographie comprenant un dispositif microélectronique à émission d'électrons tel que décrit précédemment, mis en oeuvre pour réaliser des motifs dans une couche mince 310, par exemple à base de résine reposant sur une plaque 300 (« wafer » selon la terminologie anglo-saxonne) par exemple semi-conductrice. Outre la première structure 115 apte à émettre des électrons primaires, associée à la seconde structure 140 apte à collecter des électrons primaires issus de la première structure et à produire des électrons secondaires et en particulier des faisceaux d'électrons secondaires 156, 158, un système ou des moyens de focalisation 350 de faisceaux d'électrons 156, 158, issus des nano-sources d'électrons 133 est également prévu. Ces moyens de focalisation peuvent être formés de dispositifs électrostatique(s) ou/et magnétique(s). Ce dispositif de lithographie peut comprendre également des moyens de polarisation 320 pour permettre d'appliquer un potentiel Va par exemple de l'ordre de plusieurs milliers de volts à la plaque 300, afin que cette dernière puisse former une anode.

Le rapport de taille entre les pixels 105 d'émetteurs primaires ou de micro-sources 101, et notamment entre les zones conductrices 102 et les ouvertures 133, peut être prévu de sorte, que le micro-sources ou émetteurs primaires 101 sont masqués vis-à-vis de bombardements ioniques de retour. De tels bombardements peuvent être par exemple issus d'éléments situés sur le parcours des faisceaux 156,158 comme les moyens ou diaphragmes de mise en forme 350 des faisceaux 156, 158, ou bien de l'anode. Pour des zones conductrices 102, par exemple de largeur d1 (d1 étant défini par une distance mesurée dans une direction parallèle à un vecteur ***̅i̅*̅** d'un repère orthogonal [O*; **i̅** ; **j̅** ; **k̅]̅*** représenté sur la figure 5) de l'ordre de 10 µm, et des ouvertures 133 de diamètre d2 de l'ordre de 10 nanomètres, les émetteurs primaires 101 "vus" au travers des nano-sources 133 sont écrantés vis à vis de bombardements ioniques parasites de retour. Cet écrantage des émetteurs 101 peut permettre de protéger ces derniers dans le cas éventuel d'un claquage ou d'une mise sous tension trop élevée de l'anode. Cette immunité aux claquages peut permettre d'appliquer un champ électrostatique élevé entre les source 101 et l'anode 300, ce qui peut favoriser l'obtention d'une bonne résolution d'écriture dans la couche mince 310.

La première structure et la deuxième structure solidarisées ou hybridées par les billes 122 et 124 permettent de placer les micro-sources 101 ou émetteurs primaires dans une cavité 400, qui peut être sous vide ou mise sous-vide. Le très faible diamètre d₂ des nano-sources secondaires 133, par exemple de l'ordre de 10 nanomètre peut permettre de maintenir un vide poussé dans cette cavité 400, par exemple une pression de l'ordre de 10-¹⁰ mbar. Un tel vide poussé du côté des émetteurs primaires ou micro-sources peut permettre d'améliorer la stabilité spatiale et temporelle des faisceaux 156 et 158.

WO-A-03/054901 décrit un dispositif selon le préambule de la présente Revendication 1. WO-A-03/041039 décrit un dispositif, dont le nombre N2 d'ouvertures est inférieur au nombre N1 de micro-sources.

## Revendications

1. Dispositif de lithographie doté d'un dispositif microélectronique d'émission électronique apte à émettre plusieurs faisceaux d'électrons comprenant :
- des premiers moyens (115) comportant au moins un substrat et une pluralité ou un nombre N1 de micro-sources d'électrons formées sur le substrat, avec N1 > 1,
- des seconds moyens (140) aptes à collecter des électrons issus desdites micro-sources et à émettre des électrons secondaires, lesdits seconds moyens comprenant au moins une couche dite « de collection » située en regard des micro-sources et dans laquelle est formée une pluralité ou un nombre N2 d'ouvertures, avec N2 > 1, **caractérisé par** le nombre N2 d'ouvertures étant inférieur au nombre N1 de micro-sources, les ouvertures ayant un diamètre compris entre 1 nanomètre et 50 nanomètres, les premiers moyens étant maintenus à distance des seconds moyens par plusieurs éléments conducteurs, établissant une liaison électrique et mécanique entre les premiers moyens et les seconds moyens.

2. Dispositif selon la revendication 1, les éléments conducteurs comportant des billes conductrices.

3. Dispositif selon l'une des revendications 1 ou 2, dans lequel la couche de collection appartient à un empilement de couches minces, l'empilement comprenant, de part et d'autre de la couche de collection, au moins une couche conductrice apte à former une première électrode et au moins une autre couche conductrice apte à former une seconde électrode.

4. Dispositif selon l'une des revendications 1 à 3, dans lequel les électrodes sont alimentées par plusieurs circuits intégrés dudit substrat.

5. Dispositif selon l'une des revendications 1 à 4, la couche de collection étant à base d'un matériau isolant.

6. Dispositif selon l'une des revendications 1 à 5, les ouvertures étant agencées en une matrice.

7. Dispositif selon l'une des revendications 1 à 6, dans lequel les premiers moyens comprennent une matrice de pixels, chaque pixel comportant une ou plusieurs micro-sources.

8. Dispositif selon l'une des revendications 1 à 7, comprenant en outre un circuit d'adressage des pixels.

9. Dispositif selon l'une des revendications 1 à 8, les micro-sources étant des micro-pointes, ou des nano-tubes de carbones, ou des nano-fissures.

10. Dispositif selon l'une des revendications 1 à 9, les ouvertures comportant une première embouchure de section donnée et une seconde embouchure de section supérieure à la première embouchure.

11. Dispositif selon l'une des revendications 1 à 10, la couche de collection étant à base d'un matériau de coefficient d'émission secondaire supérieur à 1.

12. Dispositif selon l'une des revendications 1 à 11, comprenant en outre : des moyens de focalisation de faisceaux d'électrons.

## Claims

1. Lithography device comprising a microelectronic electronic emission device capable of emitting several beams of electrons comprising:
- first means (115) comprising at least one substrate and a plurality or a number N1 of micro-sources of electrons formed on the substrate with N1 > 1,
- second means (140) capable of collecting electrons from said micro-sources and emitting secondary electrons, said second means comprising at least one layer known as "collection layer" situated opposite the micro-sources and wherein is formed a plurality or a number N2 of openings with N2 > 1, the number N2 of openings being less than the number N1 of micro-sources, the openings having a diameter between 1 nanometer and 50 nanometers, the first means being maintained at a distance from said second means by several conductive elements, establishing an electrical and mechanical link between first means and second means.

2. Device according to claim 2, said conductive elements comprising conductive beads.

3. Device according to claim 1 or 2, wherein the collection layer belongs to a stacking of thin films, the stacking comprising, on either side of the collection layer, at least one conductor layer capable of forming a first electrode and at least one other conductor layer capable of forming a second electrode.

4. Device according to any of claims 1 to 3, wherein the electrodes are supplied by one or several integrated circuits of said substrate.

5. Device according to any of claims 1 to 4, the collection layer being based on an insulating material.

6. Device according to any of claims 1 to 5, the openings being arranged in a matrix.

7. Device according to any of claims 1 to 6, wherein the first means comprises a matrix of pixels, each pixel comprising one or several micro-sources.

8. Device according to any of claims 1 to 7, the substrate further comprising: a pixel addressing circuit.

9. Microelectronic electronic emission device according to any of claims 1 to 8, the micro-sources being microtips, or carbon nanotubes, or nanofissures.

10. Microelectronic electronic emission device according to any of claims 1 to 9, the openings comprising a first mouth of given section and a second mouth of section greater than the first mouth.

11. Microelectronic electron emission device according to any of claims 1 to 10, the collection layer being based on a material of secondary emission coefficient greater than 1.

12. Device according to one of claims 1 to 11, further comprising: means for focusing electron beams.

## Patentansprüche

1. Lithographievorrichtung, welche mit einer mikroelektronischen Elektroden-Emissionsvorrichtung ausgestattet ist, die dazu angepasst ist, eine Mehrzahl von Elektronenstrahlen zu emittierten, umfassend:
- erste Mittel (115), welche wenigstens ein Substrat und eine Mehrzahl oder eine Anzahl N1 von Mikroelektronenquellen umfassen, welche auf dem Substrat gebildet sind, wobei N1>1,
- zweite Mittel (140), welche dazu angepasst sind, von den Mikroquellen abgegebene Elektronen zu sammeln und Sekundärelektronen zu emittieren, wobei die zweiten Mittel wenigstens eine Schicht umfassen, welche Sammelschicht genannt wird und sich gegenüber von den Mikroquellen befindet, wobei in der Schicht eine Mehrzahl oder eine Anzahl N2 von Öffnungen gebildet ist, wobei N2>1, **dadurch gekennzeichnet, dass** die Anzahl N2 von Öffnungen kleiner als die Anzahl N1 von Mikroquellen ist, wobei die Öffnungen einen Durchmesser aufweisen, welcher in dem Bereich von zwischen 1 Nanometer und 50 Nanometer liegt, wobei die ersten Mittel von den zweiten Mitteln durch eine Mehrzahl von Leiterelementen beabstandet gehalten sind, wodurch eine elektrische und mechanische Verbindung zwischen den ersten Mitteln und den zweiten Mitteln gebildet ist.

2. Vorrichtung nach Anspruch 1, wobei die Leiterelemente Leitungskugeln umfassen.

3. Vorrichtung nach einem der Ansprüche 1 oder 2, wobei die Sammelschicht zu einem Stapel von dünner Schichten gehört, wobei der Stapel beidseitig von der Sammelschicht wenigstens eine Leitungsschicht, die dazu angepasst ist, eine erste Elektrode zu bilden, und wenigstens eine andere Leitungsschicht umfasst, die dazu angepasst ist, eine zweite Elektrode zu bilden.

4. Vorrichtung nach einem der Ansprüche 1 bis 3, wobei die Elektroden durch eine Mehrzahl von integrierten Schaltkreisen des Substrats gespeist sind.

5. Vorrichtung nach einem der Ansprüche 1 bis 4, wobei die Sammelschicht auf Grundlage eines isolierenden Materials gebildet ist.

6. Vorrichtung nach einem der Ansprüche 1 bis 5, wobei die Öffnungen in einer Matrix angeordnet sind.

7. Vorrichtung nach einem der Ansprüche 1 bis 6, wobei die ersten Mittel eine Pixelmatrix umfassen, wobei jeder Pixel eine oder mehrere Mikroquellen umfasst.

8. Vorrichtung nach einem der Ansprüche 1 bis 7, ferner umfassend einen Schaltkreis zum Adressieren der Pixel.

9. Vorrichtung nach einem der Ansprüche 1 bis 8, wobei die Mikroquellen Mikrospitzen oder Kohlenstoffnanoröhren oder Nanospalte sind.

10. Vorrichtung nach einem der Ansprüche 1 bis 9, wobei die Öffnungen eine erste Mündung mit einem gegebenem Schnitt und eine zweite Mündung umfassen, welche einen Schnitt aufweist, der größer als jener der ersten Mündung ist.

11. Vorrichtung nach einem der Ansprüche 1 bis 10, wobei die Sammelschicht auf Grundlage eines Materials gebildet ist, dessen Sekundäremissionskoeffizient größer als 1 ist.

12. Vorrichtung nach einem der Ansprüche 1 bis 11, ferner umfassend Mittel zum Fokussieren von Elektronenstrahlen.
